# EUROPEAN PATENT SPECIFICATION

(11) **EP 2 328 246 B1**
(45) Date of publication and mention of the grant of the patent: **23.05.2012**
(21) Application number: 10191730.0
(22) Date of filing: 18.11.2010
(51) Int. Cl.: H02B 1/16, H02H 3/40, H02H 7/26, H02H 5/10, G01R 31/02

(54) **Electricity distribution system and method for adapting a TT electricity distribution network**
Elektrisches Verteilungssystem und Verfahren zur Anpassung eines TT Stromverteilungsnetz
Système de distribution d'électricité et procédé d'adaptation d'un réseau TT de distribution d'électricité

(30) Priority: 19.11.2009 NL 2003829
(43) Date of publication of application: 01.06.2011
(73) Proprietor: Liandon B.V., 6921 RL Duiven (NL)
(72) Inventor: van Riet, Martinus Johannes Maria, 6824 HT Arnhem (NL)
(74) Representative: Jansen, Cornelis Marinus

(56) References cited:
- WO-A1-2008/019446
- FR-A1- 2 659 744
- FR-A1- 2 697 385

## Description

The invention relates to an electricity distribution system.

From practice, different types of electricity distribution networks are known, viz. those of the TT-type and of the TN-type (IEC standard no. 60364). These systems differ in particular in the manner of earthing. With the TN-system, electricity transport cables are designed for providing end user networks with an earth line, for the purpose of coupling to a central earth (of a distribution station, for instance). This is not the case with the TT-system which provides local earth only (i.e. each end user network is locally provided with an individual earth electrode, for locally earthing end user equipment and the like). An advantage of the relatively modern TN-system is that it can provide a good earthing which is relatively insusceptible to interference with end user networks, preferably via earthed sheaths of transport cables.

However, not all end user networks are connected to a TN-system; in various areas, the older TT-system is still utilized. It appears that in some cases, from such a TT-system, irritating interferences can be generated, while switching an electric machine on and off (in particular provided with a frequency controlled electric motor) at a first end user network may lead to high frequency harmonic interference signals (greater than 1kHz) at a neighbouring end user network.

Publication FR 2 659 744 A1 discloses a portable device for fault detection in the electrical insulation of an electrical or electronic installation powered by a TT mode distribution network. The device comprises an isolation transformer coupled to a leakage current detector circuit.

Publication WO2008/019466 discloses a method for detecting a discontinuity or irregularity in a supply line of an electrical power distribution, the method including measuring a property associated with the supply line. The property may include a complex impedance associated with a neutral return line or earth return line and/or ambient electrical noise present on the supply line.

The object of the present invention is to solve the above-mentioned problems. In particular, the invention contemplates providing a safe, interference insusceptible electricity distribution system, which is based on such a TT-type network. The invention further envisages adaptation of a TT-type network for safely preventing occurrence of interference signals.

According to one aspect of the invention, to this end, there is provided an electricity distribution system as defined by the features according to claim 1.

By (locally) providing, at the end user network, an earth electrode for earthing one or more local end user earthing conductors, and coupling this earth electrode to a respective neutral line, the occurrence of so-called interference signals can be well prevented. It appears in particular that what is prevented in this way is that a local earthing system of the end user network coupled to the earth electrode is going to function as an antenna for such interference signals. The invention further offers a good protection against contact voltage on earth.

In addition, the present invention offers a desired safety, by providing a measuring device mentioned. Preferably, the measuring device can detect a breakage in the neutral line, so that action can be taken (after neutral line breakage), comprising, in particular, disconnecting the respective end user network from the phase. Thus, the dangerous situation can be prevented where the end user network, after a broken neutral line, can still receive high currents from the phase line while a return current starts flowing via the earthing connection. The invention can further protect end users from voltages on neutral and earth, which voltages can arise through a voltage distribution or neutral point shift as a result of a neutral interruption (at least, a decrease of the integrity of this neutral line).

According to an extra favourable elaboration, the system is provided with a switch which is designed for interrupting a local electric coupling between the local earth electrode and a respective neutral line of the network, preferably automatically under the influence of a fault in the neutral line detected by the measuring device.

The invention further provides a method for adapting a TT-type electricity distribution network, which network is provided with circuits comprising phase lines and neutral lines (for voltage relay between the distribution stations and the end user networks) extending between distribution stations and end user networks, wherein between at least one end user network and respective distribution station no separate earth line is provided, wherein a local earth electrode is provided at each such at least one end user network for earthing one or more local end user earthing conductors, wherein the local earth electrode is electrically coupled to a respective neutral line of the network, and wherein a measuring device is provided for monitoring integrity of the neutral line coupled to the earth electrode.

In this manner, the above-mentioned advantages can be achieved. A further elaboration of the method comprises providing a switch for regulating the electric coupling between the local earth electrode and the respective network neutral line. Here, it is preferred if the switch is controlled under the influence of measurements carried out by the measuring device. It is further advantageous when such a switch is a local main switch (or forms part thereof), which main switch also serves for regulating electric coupling between the phase lines and neutral lines of the network and local current lines.

The invention further provides the use of the innovative system. The invention provides in particular a method which is characterized by the features of claim 23.

Further elaborations of the invention are described in the subclaims. In the following, the invention is elucidated on the basis of exemplary embodiments and the drawings. In the drawings:
Fig. 1 schematically shows a part of an exemplary embodiment of an electricity network;
Fig. 2 shows a part of a network connection of an example known from the state of the art;
Fig. 3 shows a part of a network connection according to a first exemplary embodiment of the invention; and
Fig. 4 shows a part of a network connection according to a further elaboration of the invention.

In this application, identical or corresponding features are indicated with identical or corresponding reference characters.

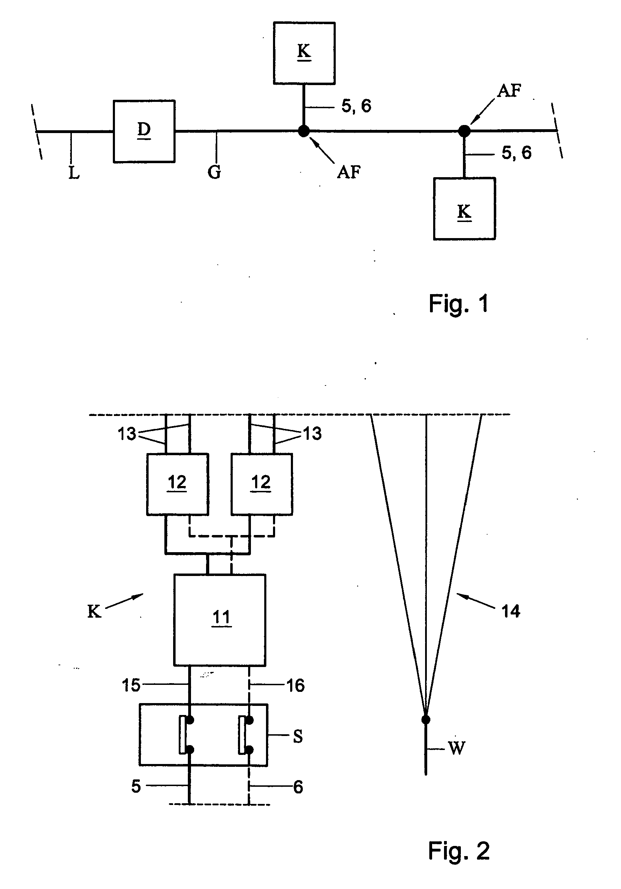

Fig. 1 shows a part of an electricity distribution system for providing local end user networks K with electricity. Each end user network K is designed in particular for locally connecting electricity consumers thereto (for instance equipment, machines, electric motors and the like) to be provided with electricity. Each end user network K can be provided in and/or at (be associated with), for instance, a particular building, dwelling, office, company and the like.

The electricity distribution system may comprise a number of downstream low voltage parts, to which the end user networks K are coupled for receiving electricity (low voltage). The term low voltage may be understood to mean, for instance, an alternating current in the range of approximately 100-1000 V, for instance an alternating current of approximately 110 Volt, or approximately 220 V. The network may be designed for supplying, as desired, a one phase current and/or multiphase current, in particular a three phase current, to end users K.

Fig. 1 shows in particular two neighbouring end user networks K, which are connected to the same distribution station D via a shared low current (voltage) network part. The latter network part comprises in particular a low voltage transport main cable G to which local networks of the end user networks are connected. Usually, the length of this cable G is limited, and is in particular no longer than 500 meters and in particular no longer than 300 meters.

The distribution station D (for instance transformer station) itself is coupled to, for instance, one or more main distribution stations and/or power stations, by means of, for instance, medium voltage or high voltage conductors L. The distribution station D is for instance designed for distributing over the end users mentioned electricity coming from hierarchically higher network parts, such as the main distribution stations and/or power plants mentioned, to hierarchically lower network elements, for instance via one or more low voltage cables G. The distribution station D can comprise, for instance, a transformer or the like, for converting high or medium voltage to the low voltage mentioned.

In particular, the system comprises operatively low voltage-carrying phase lines 5, and neutral lines 6, extending between the distribution stations D and end user networks K. In particular, the end user networks K are each connected to the distribution station D via an associated electric circuit, supplied by one or more phase lines 5 and a neutral line 6 extending therebetween. Further, as a rule, a neutral line 6 is coupled via the distribution station D to earth for the purpose of local voltage reference (via an earth electrode of the station), in particular via an earthed part of a transformer.

Each low voltage cable G has for instance three (usually parallel running) conductive phase lines 5 (for instance three respective cores) and a conductive neutral line 6 (for instance a fourth core). In the example, the low voltage cable G itself is not arranged for providing the end user networks K with a central earthing (for instance supplied via station D). The cable G has, for instance, no earthing screen. The cable G (in the case of 3-phase current) is in particular not provided with a specific fifth core serving as earth core, connected via station D to an earth electrode. In other words: the main cable G itself is provided with at most four conductors (i.e. at most three phase conductors and an associated neutral conductor). In an alternative embodiment, in the simplified case of transport of 1-phase current, such a main cable has at most two conductors (i.e. one phase conductor and one associated neutral conductor).

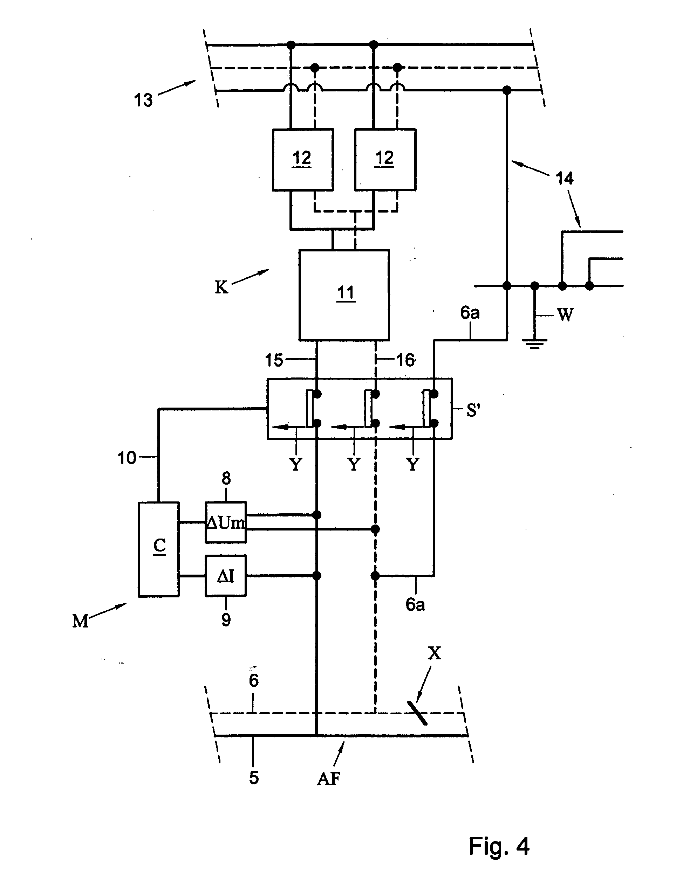

Each end user network can for instance be coupled via a suitable branch AF (see Figs. 1,4) to one or more conductive phase lines 5 of the main cable G (for receiving current from station D), and to the conductive neutral line 6 (for a return current to station D) of the cable G. Therefore, the branch AF itself can comprise one or more phase-line branches and an associated neutral line branch, but no additional earth line branch. The local end user network K and the branch AF of the low voltage part of the electricity distribution system are therefore not electrically coupled via a separate earth line.

Fig. 2 shows a coupling between a part of a local end user network K and a phase line 5 and neutral line 6 of the low voltage part of the electricity distribution system. In case of a three-phase connection, three phase lines are provided for coupling the local end user network K thereto.

Each local end user network K comprises an associated main switch S (provided with, for instance, one or more main fuses) for coupling the phase line 5 to a downstream electricity receiving part of the end user network. The local main switch S serves especially for regulating the electric coupling between the phase lines 5 and neutral lines 6 of the network and local current lines 15, 16. In an initial operating position, the main switch S couples the phase line 5 electrically to a local phase line 15, and the neutral line 6 to a local neutral line 16. The main switch S can be brought from the initial operating position to a current interrupting position. In the latter position, both the electric coupling between the network phase line 5 and local phase line 15 and the electric coupling between the network neutral line 6 and the local neutral line 16 are broken.

Further, of the remaining part of the local end user network K, only an energy meter (electric meter) 11 and local main earth leakage circuit breakers 12 are indicated, a few local conductors 13 for providing a remaining part (not represented) of the local network with current, an earth electrode W and earthed local conductors 14. The main switch S, energy meter 11 and fuses, usually with earth leakage circuit breakers, group switches and the like are for instance arranged together in a closable meter cupboard or the like.

Fig. 2 shows in particular a configuration according to the TT-type, wherein the earth electrode W (which is locally put in the ground, and locally contacts the earth, for instance, via groundwater) serves for earthing local network parts, via the one or more conductors 14 coupled to the electrode W. In certain situations, such a configuration appears to lead to undesired interference at neighbouring local end user networks K. In particular, it has appeared that sensitive equipment of a neighbouring local network K, for instance hi-fi music systems and the like, picks up electromagnetic signals which are transmitted from the other network K.

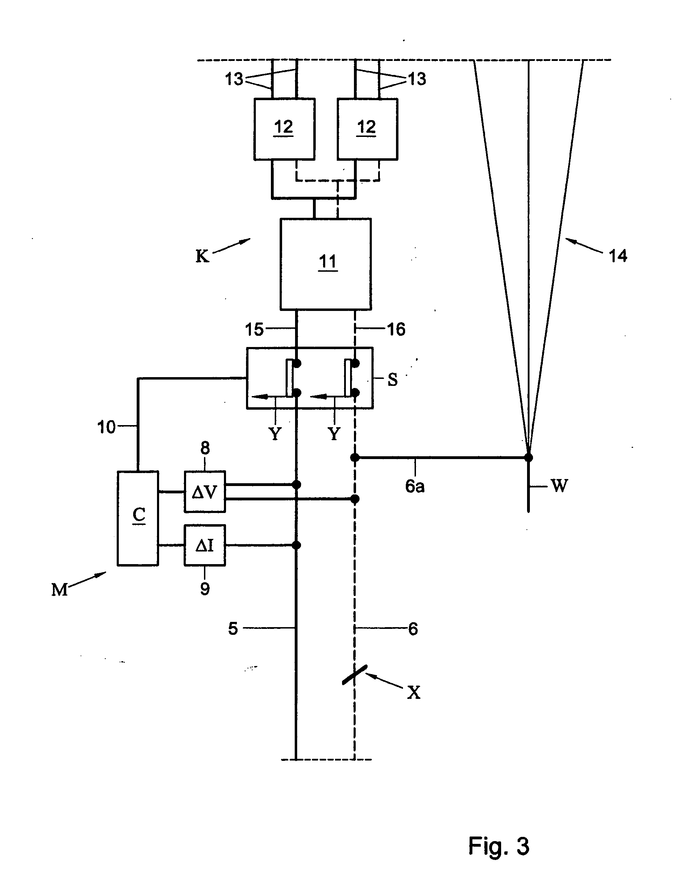

An undesirably costly solution to this problem can be replacing the main cable G by an earthed main cable, provided with specific earthing wires. Fig. 3 shows a surprisingly simple, much cheaper solution to this problem, wherein the main cable G does not need to be replaced.

Fig. 3 schematically shows an exemplary embodiment, wherein the configuration shown in Fig. 2 is adapted by electrically coupling the local earth electrode W to the neutral line 6 of the distribution network. The coupling, for instance via a conductor 6a, is done, for instance, at or near the end user network, for instance in a meter cupboard, in particular at a distance of not more than one or a few meters from the main switch S. With this adaptation, it is avoided in a simple manner that the local earthing net 14 (which is usually coupled to end user equipment and/or machines to be earthed) forms an antenna for undesired high-frequency interference signals.

A safety device is provided, for effecting that the local network K is automatically uncoupled from the main cable G of the distribution network if the neutral conductor 6 extending between the local network K and distribution station D breaks (conductor breakage is indicated in Fig. 3 by a slash X; uncoupling in the switch S is indicated with arrows Y). In this manner it is ensured that local network K is dead after such a breakage, so that it is avoided that a dangerous, uncontrolled circuit is formed (wherein the earth itself takes over the function of the broken neutral conductor).

In particular, the safety device comprises a local measuring device M, which is provided for monitoring integrity of the neutral line 6 coupled to the earth electrode W. The measuring device M is further designed for cooperation with the local main switch S, for operating this switch (i.e. bringing it to a current interrupting position) in a situation detected by the measuring device M that is related to a neutral line breakage (i.e. a decrease of the integrity of the neutral line). To this end, the main switch S can be electrically or electronically controllable.

In particular, the measuring device M is arranged locally, at a respective end user network. The measuring device can for instance be provided near the main switch S (for instance in a meter cupboard). The present measuring device M is designed for carrying out an electric measurement, which measurement provides information about the integrity of the neutral line 6.

Firstly, the present measuring device M is provided with a voltmeter 8, designed for detecting a potential difference between the neutral line 6 and associated phase line 5. The measuring device M is further provided with an ammeter 9, designed for detecting a current flowing through a phase line 5. In an alternative embodiment, the ammeter can be designed for detecting the current flowing through the neutral line 6 (instead of detection of current through the phase line 5). The present measuring device M comprises a data processor C, provided with, for instance, a microcomputer or microcontroller, designed for processing measurements generated by the meters 8, 9, and for operating the main switch S on the basis of the measuring data. The voltmeter 8 can be coupled via suitable electric contacts to local parts (situated near the main switch S) of the phase line and neutral line. Coupling is done when the main cable G of the low voltage network is temporarily rendered out of operation (i.e. rendered dead). The ammeter 9 can be provided with, for instance, a current sensor, designed for detecting the current via electromagnetic induction. The measuring device M itself can be provided with, for instance, a feed source, for instance a battery, and/or be fed by means of electricity provided via the network.

A problem with a neutral line 6, in particular a breakage X, leads to increase of the electric impedance (in this case substantially comprising the electric resistance) of the electric circuit extending between the local main switch S and distribution station D. The measuring device M is configured for observing such an increase in impedance, by determining the electric impedance based on the measurements, which impedance comprises at least the impedance of the neutral line 6. In the example, this impedance, to be determined by the measuring device M, also comprises an impedance of an associated phase line 5.

According to a further elaboration, the measuring device M can be designed for determining an average value, measured over a predetermined relatively short time period Tₘ, of an electric parameter related to the neutral line 6, in particular a momentaneous electric impedance Zₘ. Preferably, this time period Tₘ comprises at least one cycle, and preferably at least five cycles (for instance approximately ten, or more), of an AC current provided via the network. This time period Tₘ is preferably smaller than 0.5 sec, and more preferably at most 200 ms.

It is further advantageous if the measuring device M is designed for determining this parameter (i.e. impedance) at least twice per second, in at least two successive measurements, preferably at least three times.

The data processor C of the measuring device M can be designed for delivering a detection signal which is dependent on a value detected by the device M of a parameter related to the neutral line 6. The detection signal may serve as control signal, for controlling the switch S. Measuring device M can for instance be coupled via a communication line 10 to an operating part of the switch S, such that the switch can receive the control signal via the communication line 10, to be controlled thereby.

The measuring device M may be designed for steering the main switch S to the current interrupting position (via a suitable control signal), when the measuring device M detects that an instantaneous value of the parameter exceeds a threshold value.

Preferably, the measuring device M is designed for controlling the main switch S to the current breaking position (via a suitable control signal) when the measuring device detects that at least two successively measured instantaneous values of the parameter each exceed a threshold value, and preferably three successive values of the parameter. Measuring the parameter group-wise (in series) and instantaneously, and controlling the switch S on the basis thereof may prevent erroneous switching off. Here, successive (second, third) measurements serve for verification of a previous (first) measurement.

According to a further elaboration of the invention, the measuring device M is also designed for determining or estimating a nominal value of the parameter (for instance the nominal impedance), in particular by measuring an average parameter Zₐ for a relatively long period of time (while utilizing the current and voltage measurements carried out by meters 8, 9), for instance a period of time longer than one minute, for instance about 10 minutes or more. The measured average parameter Zₐ (for instance, average impedance) is then equated to the nominal value of the parameter. The nominal value may serve to provide or set a threshold value. A difference between a threshold value and a nominal value can for instance be at least 10% of the nominal value, in particular at least 20% (for instance, approximately 0.1 Ohm or more, or 0.2 Ohm or more, with impedance determination).

According to a further elaboration, a nominal electric impedance (for instance, a predetermined or measured/estimated nominal impedance) of a neutral line 6 extending between the main switch S of the end user network and distribution station D can be smaller than 0.5 Ohm, and be in the range of, for instance, approximately 0.2 - 0.3 Ohm. In that case, the measuring device M can for instance control the main switch S to the current interrupting position (via a suitable control signal), when the measuring device M detects that the instantaneous impedance of the neutral line exceeds a threshold value of 0.5 Ohm (and in particular when the measuring device M detects that at least two successive instantaneous measurements of this impedance each exceed the threshold value).

In this manner, the invention provides a local adaptation of a TT-type network part of an electricity distribution network, at the end user, to prevent annoying interferences (often related to signals which are transmitted by frequency-controlled motors via local earth parts), without drastic network adaptations being required to that end. The local electric coupling 6a between the local earth electrode W and the neutral line provides a filter for removing interference signals, while safety of the network remains guaranteed through the use of the associated monitoring of the neutral line integrity.

Fig. 4 shows an advantageous, extra safe further elaboration of the invention, which is distinguished from the system shown in Fig. 3 in that it is provided with a switch S' which is designed for interrupting a local electric coupling 6a between the local earth electrode W and a respective neutral line 6 of the network. The switch S' interrupts transport of electricity via the coupling 6a under the influence of a deterioration of the integrity (i.e. breakage X) of the neutral line detected by the measuring device M.

As shown in the drawing, it is in particular the main switch S' (which also regulates the current transport between the neutral lines and phase lines) that is provided with a(n) (additional) switch part for regulating the local electric coupling 6a between the local earth electrode W and the respective neutral line 6, and for automatically breaking the coupling when the switch S' is brought to the respective current interrupting position. As follows from Fig. 4, the present main switch S' is thereto provided with a switch part, which electrically couples together the coupling conductors 6a (for coupling the electrode W to the neutral line 6) when the main switch is in the initial operating position. With the switch S' in the current breaking position, both the phase lines 5, 15 and the neutral lines 6, 16 and the (two) coupling conductors 6a are mutually uncoupled.

Alternatively, a separate switch can be provided, operable under the influence of the measuring device M, in addition to the main switch S, for regulating local electric coupling 6a between the local earth electrode W and a respective neutral line 6 of the network.

An advantage of the second exemplary embodiment, shown in Fig. 4, is that after uncoupling as a result of detection of a breakage X, the local earth is still electrically connected to the local earth electrode W, but that no electric connection remains between the local earth electrode W and the external neutral line 6. Transport of dangerous voltage fluctuations (in particular peak voltages) to a local earth net 14, for instance just after the occurrence of a fault X in the neutral line, are thus well prevented.

For the skilled person it will be clear that the invention is not limited to the described exemplary embodiments. Various modifications are possible within the framework of the invention as set forth in the following claims.

In this application, the term "a" can for instance mean "only one" or "a number of" or "multiple".

Further, a measuring device M can for instance be designed for carrying out measurements on different phase lines and an associated neutral line, for instance if a respective end user network K is connected to multiphase current (i.e. to multiple phase lines).

## Claims

1. An electricity distribution system for providing end user networks (K) with electricity, provided with a number of electricity distribution stations (D), and circuits comprising phase lines (5) and neutral lines (6) extending between the distributions stations (D) and end user networks (K),
wherein at at least one end user network at least one local earth electrode (W) is provided for earthing one or more local end user earthing conductors (8), **characterised in that** the local earth electrode (W) is electrically coupled to a respective neutral line (6) of the network;
wherein the system comprises a measuring device (M) for monitoring integrity of the neutral line (6) coupled to the earth electrode (W).

2. A system according to claim 1, wherein the measuring device is arranged locally, at a respective end user network.

3. A system according to any one of the preceding claims, wherein the measuring device (M) is designed for carrying out an electric measurement.

4. A system according to any one of the preceding claims, wherein the measuring device (M) is designed for detecting a potential difference between a said neutral line (6) and associated phase line (5).

5. A system according to any one of the preceding claims, wherein the measuring device (M) is designed for detecting a current flowing through a said phase line (5), or for detecting a current flowing through said neutral line (6).

6. A system according to any one of the preceding claims, wherein the measuring device (M) is configured for determining an electric impedance, which impedance comprises at least an impedance of the neutral line (6).

7. A system according to claim 6, wherein the impedance also comprises an impedance of one or more associated phase lines (5).

8. A system according to any one of the preceding claims, wherein the measuring device (M) is designed for determining an average value, measured over a predetermined period of time, of an electric parameter related to the neutral line (6).

9. A system according to claim 8, wherein said period of time comprises at least one cycle, and preferably at least five, of an alternating current provided via the network, wherein said period of time is preferably at most 0.5 sec, more preferably at most 200 ms.

10. A system according to any one of claims 8 - 9, wherein the measuring device (M) is designed for determining said parameter at least twice per second, in at least two successive measurements, preferably at least three times.

11. A system according to any one of the preceding claims, wherein the measuring device (M) is designed for delivering a detection signal which is dependent on a value detected by the device (M) of a parameter related to the neutral line.

12. A system according to any one of the preceding claims, wherein a nominal electric impedance of a neutral line extending between the end user network and distribution station (D) is smaller than 0.5 Ohm, and is in the range of, for instance, approximately 0.2 - 0.3 Ohm.

13. A system according to any one of the preceding claims, wherein at each said end user network a local main switch (S) is provided, for coupling the phase line (5) to a downstream electricity receiving part of the end user, wherein at least one said main switch (S) is controllable under the influence of a respective measuring device (M).

14. A system according to claim 13, wherein the mains switch (S) interrupts electricity supply via the phase line (5) under the influence of a deterioration of the integrity of the neutral line detected by the measuring device (M).

15. A system according to any one of the preceding claims, provided with a switch (S') which is designed for interrupting a local electric coupling (6a) between the local earth electrode (W) and a respective neutral line (6) of the network, wherein the switch (S') interrupts electricity transport via this local coupling (6a) under the influence of a deterioration of the integrity of the neutral line detected by the measuring device (M).

16. A system according to claim 15 in combination with claim 13 or 14, wherein said main switch is provided with a switch part for regulating the local electric coupling (6a) between the local earth electrode (W) and the respective neutral line (6).

17. A system according to any one of the preceding claims, wherein each distribution station (D) is designed for converting high voltage or medium voltage into low voltage, which low voltage is provided via said phase lines (5) to the end user networks.

18. A system according to any one of the preceding claims, wherein no earth line is provided between the end user network provided with the local earth electrode (W) and the distribution station (D).

19. A method for adapting a TT-type electricity distribution network, which network is provided with circuits comprising phase lines (5) and neutral lines (6) extending between distribution stations (D) and end user networks (K), but no earth lines extending between distribution stations (D) and end user networks (K), wherein a local earth electrode (W) is provided at an end user network, for earthing one or more local end user earthing conductors (8), **characterised in that** the local earth electrode (W) is electrically coupled to a respective neutral line (6) of the network, and wherein a measuring device (M) is provided for monitoring integrity of the neutral line (6) coupled to the earth electrode (W).

20. A method according to claim 19, wherein a switch (S') is provided for regulating the electric coupling between the local earth electrode (W) and the respective network neutral line (6).

21. A method according to claim 20, wherein the switch (S') is controlled under the influence of measurements carried out by the measuring device (M).

22. A method according to claim 19 or 20, wherein the switch is a local main switch (S') or forms part thereof, which main switch also serves for regulating electric coupling between the phase lines (5) and neutral lines (6) of the network and local current lines (15, 16).

23. A method for electricity distribution, comprising the use of a system according to any one of claims 1- 19, wherein the measuring device (M) monitors integrity of the neutral line (6) coupled to a said local earth electrode (W).

24. A method according to claim 23 in combination with claim 14 wherein the measuring device (M) detects deterioration of the integrity of the neutral line, wherein the main switch (S) under the influence of the detection of the deterioration of the integrity is automatically brought to a current interrupting position.

25. A method according to claim 23 in combination with claim 15, wherein the measuring device (M) detects deterioration of the integrity of the neutral line, wherein under the influence of the detection of the deterioration of the integrity, the local electric coupling (6a) between the local earth electrode (W) and the respective neutral line (6) of the network is automatically interrupted.

## Patentansprüche

1. Elektrizitätsverteilungssystem zur Elektrizitätsversorgung von Endverbraucher-Netzwerken (K), versehen mit einer Anzahl von Elektrizitätsverteilungsstationen (D) und mit Schaltungen, die Phasenleitungen (5) und zwischen den Verteilungsstationen (D) und den Endverbraucher-Netzwerken (K) verlaufende neutrale Leitungen (6) aufweisen,
wobei an mindestens einem Endverbraucher-Netzwerk mindestens eine lokale Erdungselektrode (W) zum Erden eines oder mehrerer lokaler Endverbraucher-Erdungsleiter (8) vorgesehen ist, **dadurch gekennzeichnet, dass** die lokale Erdungselektrode (W) elektrisch mit einer jeweiligen neutrale Leitung (6) des Netzwerks gekoppelt ist;
wobei das System eine Messvorrichtung (M) zum Überwachen der Integrität der mit der Erdungselektrode (W) gekoppelten neutralen Leitung (6) aufweist.

2. System nach Anspruch 1, bei dem die Messvorrichtung lokal an einem jeweiligen Endverbraucher-Netzwerk angeordnet ist.

3. System nach einem der vorhergehenden Ansprüche, bei dem die Messvorrichtung (M) zum Ausführen einer Elektrizitätsmessung ausgebildet ist.

4. System nach einem der vorhergehenden Ansprüche, bei dem die Messvorrichtung (M) zum Detektieren einer Potenzialdifferenz zwischen einer der neutralen Leitungen (6) und der zugehörigen Phasenleitung (5) ausgebildet ist.

5. System nach einem der vorhergehenden Ansprüche, bei dem die Messvorrichtung (M) zum Detektieren eines durch eine Phasenleitung (5) fließenden Stroms oder zum Detektieren eines durch die neutrale Leitung (6) fließenden Stroms ausgebildet ist.

6. System nach einem der vorhergehenden Ansprüche, bei dem die Messvorrichtung (M) zum Bestimmen einer elektrischen Impedanz konfiguriert ist, die mindestens eine Impedanz der neutralen Leitung (6) aufweist.

7. System nach Anspruch 6, bei dem die Impedanz ferner eine Impedanz einer oder mehrerer zugehöriger Phasenleitungen (5) aufweist.

8. System nach einem der vorhergehenden Ansprüche, bei dem die Messvorrichtung (M) zum Ausführen eines über eine vorbestimmte Zeitperiode gemessenen Mittelwerts eines auf die neutrale Leitung (6) bezogenen elektrischen Parameters ausgebildet ist.

9. System nach Anspruch 8, bei dem die Zeitperiode mindestens einen Zyklus und vorzugsweise mindestens fünf Zyklen eines über das Netzwerk zugeführten Wechselstroms aufweist, wobei die Zeitperiode vorzugsweise höchstens 0,5 s und besonders bevorzugt höchstens 200 ms beträgt.

10. System nach einem der Ansprüche 8-9, bei dem die Messvorrichtung (M) derart ausgebildet ist, dass sie den Parameter mindestens zweimal und vorzugsweise mindestens dreimal pro Sekunde in mindestens zwei aufeinanderfolgenden Messungen bestimmt.

11. System nach einem der vorhergehenden Ansprüche, bei dem die Messvorrichtung (M) zum Zuführen eines Detektionssignals ausgebildet ist, das von einem von der Vorrichtung (M) detektierten Wert eines auf die neutrale Leitung bezogenen Parameters abhängt.

12. System nach einem der vorhergehenden Ansprüche, bei dem eine elektrische Nennimpedanz einer zwischen dem Endverbraucher-Netzwerk und den Verteilungsstationen (D) verlaufenden neutralen Leitung kleiner als 0,5 Ohm ist und im Bereich von z.B. ungefähr 0,2 - 0,3 Ohm liegt.

13. System nach einem der vorhergehenden Ansprüche, bei dem an jedem Endverbraucher-Netzwerk ein lokaler Hauptschalter (S) vorgesehen ist, um die Phasenleitung (5) mit einem stromabwärts gelegenen Elektrizitätsempfangsteil des Endverbrauchers zu verbinden, wobei mindestens ein Hauptschalter (S) unter dem Einfluss einer jeweiligen Messvorrichtung (M) steuerbar ist.

14. System nach Anspruch 13, bei dem der Hauptschalter (S) die über die Phasenleitung (5) erfolgende Elektrizitätszufuhr unter dem Einfluss einer von der Messvorrichtung (M) detektierten Verschlechterung der Integrität der neutralen Leitung unterbricht.

15. System nach einem der vorhergehenden Ansprüche, versehen mit einem Schalter (S'), der zum Unterbrechen einer lokalen elektrischen Verbindung (6a) zwischen der lokalen Erdungselektrode (W) und einer jeweiligen neutralen Leitung (6) des Netzwerks ausgebildet ist, wobei der Schalter (S') den über diese lokale Verbindung (6a) erfolgenden Elektrizitätstransport unter dem Einfluss einer von der Messvorrichtung (M) detektierten Verschlechterung der Integrität der neutralen Leitung unterbricht.

16. System nach Anspruch 15 in Kombination mit Anspruch 13 oder 14, bei dem der Hauptschalter mit einem Schalterteil zum Regeln der lokalen elektrischen Verbindung (6a) zwischen der lokalen Erdungselektrode (W) und der jeweiligen neutralen Leitung (6) versehen ist.

17. System nach einem der vorhergehenden Ansprüche, bei dem jede Verteilungsstation (D) zum Umsetzen von Hochspannung oder mittlerer Spannung in Niedrigspannung ausgebildet ist, wobei die Niedrigspannung über die Phasenleitungen (5) den Endverbraucher-Netzwerken zugeführt wird.

18. System nach einem der vorhergehenden Ansprüche, bei dem die Erdungsleitung zwischen dem mit der lokalen Erdungselektrode (W) versehenen Endverbraucher-Netzwerk und der Verteilungsstation (D) vorgesehen ist.

19. Verfahren zum Anpassen eines Elektrizitätsverteilungsnetzwerks vom TT-Typ, das mit Schaltungen versehen ist, die Phasenleitungen (5) und zwischen Verteilungsstationen (D) und Endverbraucher-Netzwerken (K) verlaufende neutrale Leitungen (6), jedoch keine zwischen Verteilungsstationen (D) und Endverbraucher-Netzwerken (K) verlaufende Erdungsleitungen aufweisen, wobei an mindestens einem Endverbraucher-Netzwerk mindestens eine lokale Erdungselektrode (W) zum Erden eines oder mehrerer lokaler Endverbraucher-Erdungsleiter (8) vorgesehen ist, **dadurch gekennzeichnet, dass** die lokale Erdungselektrode (W) elektrisch mit einer jeweiligen neutralen Leitung (6) des Netzwerks gekoppelt ist, und wobei eine Messvorrichtung (M) zum Überwachen der Integrität der mit der Erdungselektrode (W) gekoppelten neutralen Leitung (6) vorgesehen ist.

20. Verfahren nach Anspruch 19, bei dem ein Schalter (S') zum Regeln der lokalen elektrischen Verbindung zwischen der lokalen Erdungselektrode (W) und der jeweiligen neutralen Netzwerk-Leitung (6) vorgesehen ist.

21. Verfahren nach Anspruch 20, bei dem der Schalter (S') unter dem Einfluss von der Messvorrichtung (M) durchgeführter Messungen gesteuert wird.

22. Verfahren nach Anspruch 19 oder 20, bei dem der Schalter ein lokaler Hauptschalter (S') ist oder einen Teil derselben bildet, wobei der Hauptschalter ferner zum Regeln der elektrischen Verbindung zwischen den Phasenleitungen (5) und den neutralen Leitungen (6) der Netzwerk- und Lokal-Stromleitungen (15,16) dient.

23. Verfahren zur Elektrizitätsverteilung unter Verwendung eines Systems nach einem der Ansprüche 1-19, bei dem die Messvorrichtung (M) die Integrität der mit der lokalen Erdungselektrode (W) gekoppelten neutralen Leitung (6) überwacht.

24. Verfahren nach Anspruch 23 in Kombination mit Anspruch 14, bei dem die Messvorrichtung (M) eine Verschlechterung der Integrität der neutralen Leitung detektiert, wobei der Hauptschalter (S) unter dem Einfluss der Detektion der Verschlechterung der Integrität automatisch in eine Stromunterbrechungsposition versetzt wird.

25. Verfahren nach Anspruch 23 in Kombination mit Anspruch 15, bei dem die Messvorrichtung (M) eine Verschlechterung der Integrität der neutralen Leitung detektiert, wobei unter dem Einfluss der Detektion der Verschlechterung der Integrität die lokale elektrische Verbindung (6a) zwischen der lokalen Erdungselektrode (W) und der jeweiligen neutralen Leitung (6) des Netzwerks automatisch unterbrochen wird.

## Revendications

1. Système de distribution d'électricité, pour fournir en électricité des réseaux d'utilisateur final (K), équipé d'une pluralité de stations de distribution d'électricité (D), et de circuits comprenant des lignes de phase (5) et des lignes de neutre (6) s'étendant entre les stations de distribution (D) et des réseaux d'utilisateur final (K),
dans lequel au moins un réseau d'utilisateur final et au moins une électrode de terre locale (W) sont prévus pour mettre à la terre un ou plusieurs conducteurs de mise à la terre (8) d'utilisateur final local, **caractérisé en ce que** l'électrode de terre locale (W) est couplée électriquement à une ligne de neutre (6) respective du réseau ;
dans lequel le système comprend un dispositif de mesure (M) pour surveiller l'intégrité de la ligne de neutre (6) couplée à l'électrode de terre (W).

2. Système selon la revendication 1, dans lequel le dispositif de mesure est agencé localement, à un réseau d'utilisateur final respectif.

3. Système selon l'une quelconque des revendications précédentes, dans lequel le dispositif de mesure (M) est conçu pour effectuer une mesure électrique.

4. Système selon l'une quelconque des revendications précédentes, dans lequel le dispositif de mesure (M) est conçu pour détecter une différence de potentiel entre ladite ligne de neutre (6) et une ligne de phase (5) associée.

5. Système selon l'une quelconque des revendications précédentes, dans lequel le dispositif de mesure (M) est conçu pour détecter un courant passant par une dite ligne de phase (5), ou pour détecter un courant passant par ladite ligne de neutre (6).

6. Système selon l'une quelconque des revendications précédentes, dans lequel le dispositif de mesure (M) est configuré pour déterminer une impédance électrique, ladite impédance comprenant au moins une impédance de la ligne de neutre (6).

7. Système selon la revendication 6, dans lequel l'impédance comprend également une impédance d'une ou plusieurs lignes de phase (5) associées.

8. Système selon l'une quelconque des revendications précédentes, dans lequel le dispositif de mesure (M) est conçu pour déterminer une valeur moyenne, mesurée sur une période de temps prédéterminée, d'un paramètre électrique lié à la ligne de neutre (6).

9. Système selon la revendication 8, dans lequel ladite période de temps comprend au moins un cycle et, de préférence, au moins cinq, d'un courant alternatif fourni via le réseau, dans lequel ladite période de temps est de préférence d'au plus 0,5 sec, de manière mieux préférée d'au plus 200 ms.

10. Système selon l'une quelconque des revendications 8 à 9, dans lequel le dispositif de mesure (M) est conçu pour déterminer ledit paramètre au moins deux fois par seconde, en au moins deux mesures successives, de préférence au moins trois fois.

11. Système selon l'une quelconque des revendications précédentes, dans lequel le dispositif de mesure (M) est conçu pour délivrer un signal de détection dépendant d'une valeur détectée par le dispositif (M) d'un paramètre lié à la ligne de neutre.

12. Système selon l'une quelconque des revendications précédentes, dans lequel une impédance électrique nominale d'une ligne de neutre s'étendant entre le réseau d'utilisateur final et une station de distribution (D) est inférieure à 0,5 Ohm, et est dans la fourchette de, par exemple, à peu près 0,2 à 0,3 Ohm.

13. Système selon l'une quelconque des revendications précédentes, dans lequel un interrupteur principal (S) local est prévu à chaque dit réseau d'utilisateur final, pour coupler la ligne de phase (5) à une partie réceptrice d'électricité aval de l'utilisateur final, dans lequel au moins un dit interrupteur principal (S) est susceptible d'être commandé sous l'influence d'un dispositif de mesure (M) respectif.

14. Système selon la revendication 13, dans lequel l'interrupteur principal (S) interrompt la fourniture d'électricité via la ligne de phase (5), sous l'influence d'une détérioration de l'intégrité de la ligne de neutre, détectée par le dispositif de mesure (M).

15. Système selon l'une quelconque des revendications précédentes, équipé d'un interrupteur (S') conçu pour interrompre un couplage électrique local (6a) entre l'électrode de terre locale (W) et une ligne de neutre (6) respective du réseau, dans lequel l'interrupteur (S') interrompt le transport d'électricité via ce couplage local (6a), sous l'influence d'une détérioration de l'intégrité de la ligne de neutre, détectée par le dispositif de mesure (M).

16. Système selon la revendication 15, en combinaison avec la revendication 13 ou 14, dans lequel ledit interrupteur principal est équipé d'une partie d'interrupteur pour réguler le couplage électrique local (6a) entre l'électrode de terre locale (W) et la ligne de neutre (6) respective.

17. Système selon l'une quelconque des revendications précédentes, dans lequel chaque station de distribution (D) est conçue pour convertir une haute tension ou une moyenne tension en une basse tension, ladite basse tension étant fournie aux réseaux d'utilisateur final via lesdites lignes de phase (5).

18. Système selon l'une quelconque des revendications précédentes, dans lequel aucune ligne de terre n'est prévue entre le réseau d'utilisateur final équipé de l'électrode de terre locale (W) et la station de distribution (D).

19. Procédé d'adaptation d'un réseau TT de distribution d'électricité, ledit réseau étant équipé de circuits comprenant des lignes de phase (5) et des lignes de neutre (6) s'étendant entre des stations de distribution (D) et des réseaux d'utilisateur final (K), mais aucune ligne de terre ne s'étendant entre des stations de distribution (D) et des réseaux d'utilisateur final (K), dans lequel une électrode de terre locale (W) est prévue à un réseau d'utilisateur final, pour mettre à la terre un ou plusieurs conducteurs de mise à la terre (8) d'utilisateur final local, **caractérisé en ce que** l'électrode de terre locale (W) est couplée électriquement à une ligne de neutre (6) respective du réseau, et dans lequel un dispositif de mesure (M) est prévu pour surveiller l'intégrité de la ligne de neutre (6) couplée à l'électrode de terre (W).

20. Procédé selon la revendication 19, dans lequel un interrupteur (S') est prévu pour réguler le couplage électrique entre l'électrode de terre (W) et la ligne de neutre (6) respective.

21. Procédé selon la revendication 20, dans lequel l'interrupteur (S') est commandé sous l'influence de mesures effectuées par le dispositif de mesure (M).

22. Procédé selon la revendication 19 ou 20, dans lequel l'interrupteur est un interrupteur principal local (S') ou fait partie de celui-ci, ledit interrupteur principal servant également à réguler le couplage électrique entre les lignes de phase (5) et les lignes de neutre (6) du réseau et les lignes de courant local (15, 16).

23. Procédé de distribution d'électricité, comprenant l'utilisation d'un système selon l'une quelconque des revendications 1 à 19, dans lequel le dispositif de mesure (M) surveille l'intégrité de la ligne de neutre (6) couplée à ladite électrode de terre locale (W).

24. Procédé selon la revendication 23, en combinaison avec la revendication 14, dans lequel le dispositif de mesure (M) détecte des détériorations de l'intégrité de la ligne de neutre, dans lequel l'interrupteur principal (S), sous l'influence de la détection de la détérioration de l'intégrité, est automatiquement placé en une position d'interruption de courant.

25. Procédé selon la revendication 23, en combinaison avec la revendication 15, dans lequel le dispositif de mesure (M) détecte la détérioration de l'intégrité de la ligne de neutre, dans lequel, sous l'influence de la détection de la détérioration de l'intégrité, le couplage électrique local (6a), entre l'électrode de terre locale (W) et la ligne de neutre (6) respective du réseau, est interrompu automatiquement.
